Europäisches Patentamt

European Patent Office

Office européen des brevets

(11) Publication number: **0 354 056 A2**

(12) # EUROPEAN PATENT APPLICATION

(21) Application number: **89307955.8**

(51) Int. Cl.5: **H 01 L 23/28**

(22) Date of filing: **04.08.89**

(30) Priority: **05.08.88 JP 195685/88**

(43) Date of publication of application:
**07.02.90 Bulletin 90/06**

(84) Designated Contracting States: **DE FR GB**

(71) Applicant: **SEMICONDUCTOR ENERGY LABORATORY CO., LTD.**
**398 Hase**
**Atsugi-shi Kanagawa-ken, 243 (JP)**

(72) Inventor: **Yamazaki, Shunpei**
**Kitakarasuyama 7-chome Setagaya-ku**
**Tokyo 157 (JP)**

**Urata, Kazuo**
**13-10, 381-1, Hase**
**Atsugi-shi Kanagawa-ken, 243 (JP)**

**Koyama, Itaru**
**410-2-16-104, Shimoohtuki**
**Hatano-shi Kanagawa-ken, 257 (JP)**

**Ishida, Noriya**
**Flat Atsugi 207 931-1, Hase**
**Atsugi-shi Kanagawa-ken, 243 (JP)**

**Sadaki, Mari**
**Flat SEL 303 304-1, Hase**
**Atsugi-shi Kanagawa-ken, 243 (JP)**

**Imatou, Shinji**
**Flat Atsugi 303 931-1, Hase**
**Atsugi-shi Kanagawa-ken, 243 (JP)**

**Nakashita, Kazuhisa**
**Flat SEL 205 304-1, Hase**
**Atsugi-shi Kanagawa-ken, 243 (JP)**

**Hirose, Naoki**
**Flat Atsugi 205 931-1, Hase**
**Atsugi-shi Kanagawa-ken, 243 (JP)**

(74) Representative: **Milhench, Howard Leslie et al**
**R.G.C. Jenkins & Co. 26 Caxton Street**
**London SW1H 0RJ (GB)**

The title of the invention has been amended (Guidelines for Examination in the EPO, A-III, 7.3).

(54) **Coated electric devices and methods of manufacturing the same.**

(57) An improved electric device and manufacturing method for the same are described. The device is for example an IC chip with associated leads encapsulated within a moulded plastics package. In advance of the moulding process, the IC chip and its associated lead structure is coated with silicon nitride or other electrically insulating material in order to protect the IC chip from moisture invasions through cracks or gaps in the encapsulation. The coating of the silicon nitride is advantageously carried out after cleaning of the surfaces of the IC chip and its associated structures by plasma cleaning in a plasma CVD apparatus which is then utilized for the silicon nitride coating process.

EP 0 354 056 A2

## Description

## Electric Devices and Methods of Manufacturing the Same

### BACKGROUND OF THE INVENTION

The present invention generally relates to electric devices and methods of manufacturing the same.

Semiconductor integrated circuits, for example, are most important electric devices which are widely used in a variety of fields. One of the problems of integrated circuits, however, from the view point of reliability arises from invasion of moisture or other impurities into the IC chips after they have been encapsulated in plastics moulding material, such invasion taking place through cracks or gaps in the encapsulation which form paths from outside of the encapsulation to the surface of the IC chip. Any moisture for example which reaches the IC surface will cause undesirable corrosion of the semiconductor constituting the IC chip and lead to malfunction of the chip.

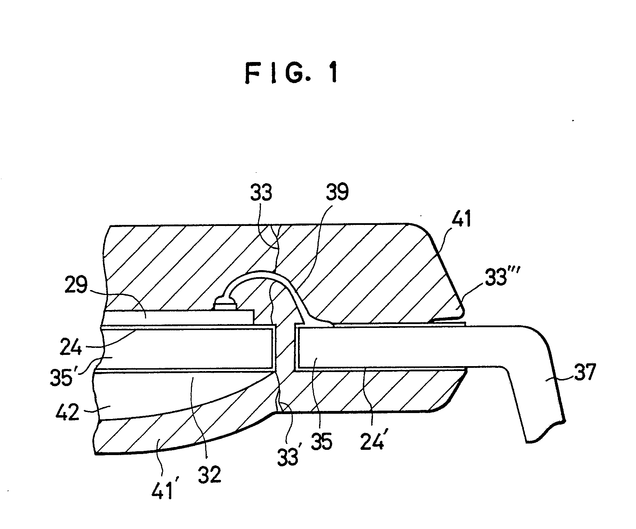

Fig. 1 of the accompanying drawings is an illustration showing how defects can be formed in a packaged IC device. The structure comprises an IC semiconductor chip 29 mounted on a base 35, a lead frame with leads 37 with which the terminations on the IC chip 29 are electrically coupled by means of Au wiring 39, and epoxy moulding material 41 encapsulating the IC chip and the lead frame. The surfaces of the base and/or of the lead frame tend to oxidize and form suboxide films 24, 24' and 32 and moisture tends to gather near the interfaces between these layers and the encapsulation. When the IC device is assembled onto an electrical circuit board and soldering is performed, the IC device is exposed to the temperature of molten solder at 260°C for example for a time period of from 3 to 10 seconds. The IC is thus subjected to a rapid change in temperature which often causes cracks to appear in the encapsulation as designated by 33, 33' and 33". Also, any moisture trapped within the encapsulation will evaporate and cause swellings such as that shown at 41' with cavities 42 being formed by the vapour pressure and resulting in cracks 33'. This swelling is particularly likely since the oxide film 32 weakens the adhesion of the encapsulation to the base 35. Other electric devices than integrated circuits are subject to the same kind of problems.

### OBJECTS AND SUMMARY OF THE INVENTION

It is therefore an object of the present invention to provide a more reliable electric device and a method of manufacturing the same, the device being immune to the above problems which as explained can give rise to moisture or other impurities invading through cracks or other paths in the encapsulation of prior art devices, or at least being improved in these respects as compared to the prior art devices.

In accordance with the present invention, the above and other objects can be achieved by plasma cleaning the device proper before it is encapsulated and preferably, though not essentially, by also providing an insulating layer on the device proper before it is encapsulated. By plasma cleaning the device surface before encapsulation the entrapment of moisture or other contaminants within the encapsulation can be dramatically reduced, and by coating the device with an insulating layer protection of the device is substantially assured even if cracks or fissures do develop for whatever reason in the encapsulation. Tests that we have conducted have shown a significant and dramatic increase in the reliability of electrical devices produced in this way.

According to the present invention, in one of its aspects, there is therefore provided an electric device comprising a device proper having at least one surface which has been treated by plasma cleaning, and an enclosure made of an organic resin material encapsulating said device proper.

In another aspect, the present invention provides a method of manufacturing electric devices comprising making electrical connection between a device proper and at least one associated lead, cleaning the surface of said device proper by plasma treatment, and encapsulating said device proper and said lead in organic resin material with a portion of said at least one lead extending from the encapsulation.

Since the practice of the invention requires plasma cleaning of the device proper, it is convenient and advantageous to effect this in a plasma CVD apparatus which is used, after the plasma cleaning step, for depositing a protective insulating layer such as of silicon nitride for example over the device prior to its encapsulation.

Other features of the invention are set forth with particularity in the appended claims and, together with the features abovementioned, will best be understood from consideration of the following explanations given with reference to the accompanying drawings.

### BRIEF DESCRIPTION OF THE DRAWINGS

Fig. 1 as abovementioned is an explanatory cross-section illustrating disadvantages of prior art devices;

Fig. 2 is a schematic diagram showing a plasma CVD apparatus for use in the practice of the present invention;

Fig. 3(A) is a schematic plan view showing a lead frame structure for supporting twelve IC devices,

Fig. 3(B) is an enlarged view showing one unit of the 12-unit lead frame illustrated in Fig. 3(A), and

Fig. 3(C) is a schematic view showing how multiple lead frames may be supported in jigs; and

Fig. 4 is a cross-section showing part of an IC device in accordance with the present invention.

### DETAILED DESCRIPTION OF THE EMBODIMENTS

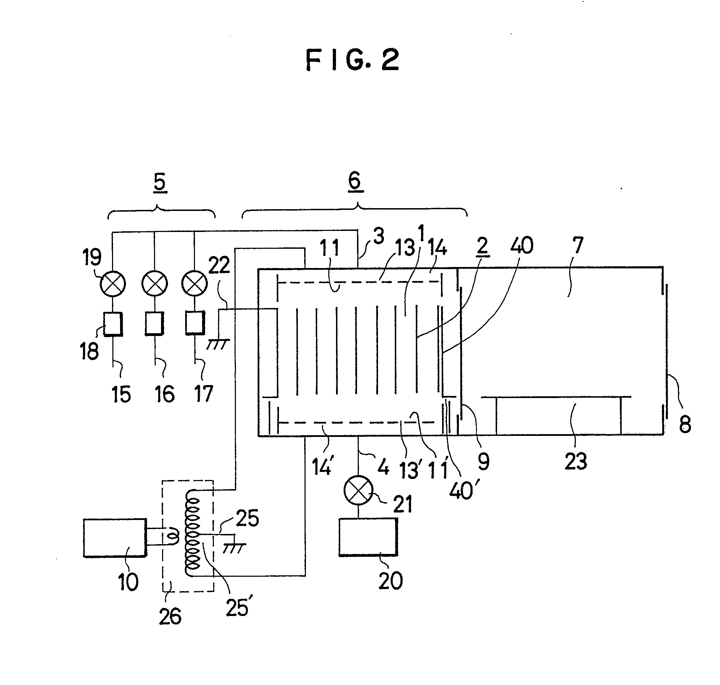

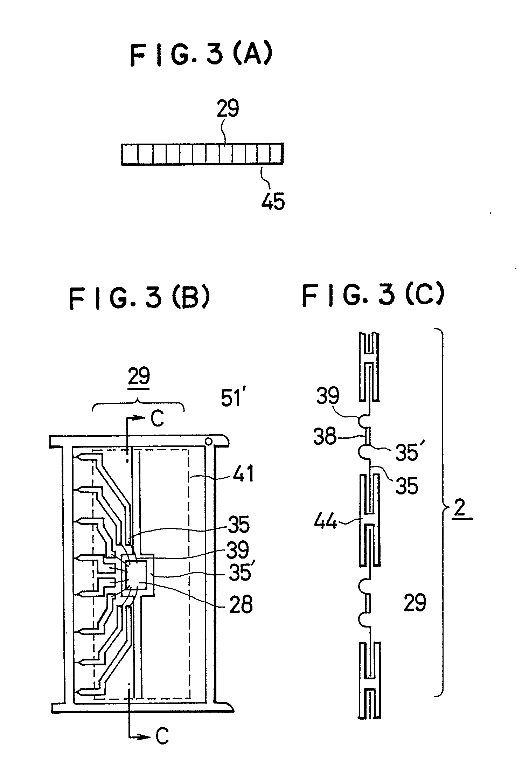

Referring now to Figs. 2 and 3(A) to 3(C), a plasma processing method in accordance with an embodiment of the present invention will hereinafter be described. Fig. 2 is a schematic cross-sectional diagram showing a plasma CVD apparatus. The apparatus comprises a deposition chamber 1, a loading-unloading chamber 7 coupled to the deposition chamber 1 through a gate valve 9, a pair of mesh or grid electrodes 11 and 14 provided in the deposition chamber 1, a gas supply system 5, a vacuum pump 20 connected to the chamber 1 through a valve 21, and a high frequency power source 10 for supplying electrical energy between the electrode 11 and 14 through a transformer 26. The mid point 25 of the secondary coil of the transformer 26 is grounded at 25. The gas supply system includes three sets of flow rate meters 18 and valves 19. The high frequency energy inputted to the electrodes 11 and 14 causes positive columm glow discharge therebetween. The glow discharge region (deposition region) is confined by a four-sided frame 40 in order to avoid undesirable deposition outside the region. The frame 40 is supported by a support means 40' and may be a grounded metal frame or an insulating frame. Within the deposition region, a number of IC chip carriers 2 are supported by the frame 40 and are disposed in parallel with each other and spaced apart by intervals of from 3 to 13 cm, e.g. 8 cm. A plurality of IC chips are mounted on each carrier 2.

The chip carriers are comprised of holding jigs 44 which serve to support lead frames 29 interposed between and supported by adjacent jigs 44 as illustrated in Figs. 3(A) to 3(C). IC chips are mounted on appropriate parts (centre bases) of the several units making up the lead frames 29 and are electrically connected to the ends of the leads of the lead frames arranged therearound by means of Au wiring 39. The surfaces of the centre bases are formed to be relatively rough in order to enhance the strength of their bonding to the encapsulation which is to be provided in the following process. Fig. 3(B) shows one unit of the lead frame 29 and as can be seen each unit is provided with the leads necessary for one IC chip package as defined by broken line 41; illustration of the leads on the right hand side of the chip package is dispensed with in the figure. This unit structure is repeated along the length of the lead frame 29 between the upper and lower rails of the lead frame as is schematically shown in Fig. 3(A). One lead frame 29 may contain from 5 to 25 unit structures as exemplified by the lead frame of Fig. 3(A) which has 12 units. A number of the jigs 44 may be integrally assembled in order to support from 10 to 50 of the lead frames 29 therebetween as shown schematically in Fig. 3(C) where the lead frames 29 are supported in grooves in the jigs 44; alternatively, the lead frames 29 could be suspended at holes 51 by pins (not shown) formed on the jigs.

Next, the provision of a protective film coating on the IC chips will be explained. First, a number of lead frames 29 are mounted on the carriers 2 after completing the electrical connections between the chips and the associated leads of the lead frames. The carriers are then introduced into the deposition chamber at a constant spacing from each other through the loading-unloading chamber 7. In advance of the actual deposition of the protective film, the external surfaces of the IC devices are cleaned. In particular, suboxide films are removed from the IC surfaces. After evacuating the deposition chamber, Ar gas is admitted to the deposition chamber 1 at 0.01 to 1 Torr from the gas supply system 5 through a nozzle 3. The Ar gas is then converted into its plasma state by inputting energy of 1 KW at 13.56 MHz in order to establish a glow discharge in the chamber 1, and plasma cleaning of the IC chips is effected for from 10 to 30 minutes. By virtue of this cleaning, lower films coated on the surfaces of the lead frames are eliminated. Next, $NH_3$, $Si_2H_6$ and $N_2$ (carrier gas) are admitted through the nozzle 3 at 0.01 to 1 Torr into the deposition chamber 1 respectively from the introduction ports 15, 16 and 17 at appropriate pressures. The introduction molar ratio of $NH_3/Si_2H_6/N_2$ is 1/3/5. Positive columm glow discharge takes place when high frequency energy is input to the pair of electrodes 11 and 14 at 1 KW and from 1 to 500 MHz, e.g. 13.56 MHz. As a result, a silicon nitride coating is deposited on the chips, on the leads and on the connections therebetween. The thickness of the coating can reach 1000 ± 200 angstroms if the deposition is continued for 10 minutes. The average deposition speed is about 3 angstroms/sec.

After completing the deposition, the carriers 2 are removed from the chamber and undergo an encapsulation process. Each carrier is placed in a moulding apparatus just as it is. By use of appropriate moulding dies, an epoxy material (410A) is injected around each chip to encapsulate the chips and form the external chip packages. After removing the carriers from the moulding apparatus, the IC's are separated from the lead frames by severing the leads. Each lead, which extends beyond the encapsulation, is then bent downwardly in order to form the legs of the IC package. The leads are cleaned by acid washing, and are then subjected to solder plating.

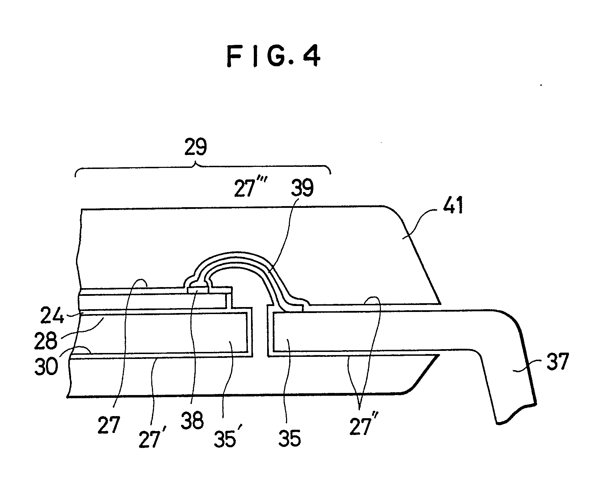

The structure of the wiring connections in an IC chip according to the invention is illustrated in Fig. 4. As shown, a protective film of silicon nitride covers the surfaces of the IC chip mounted on the base 35', the contacts 38, the Au wiring 39 and the leads 37. By virtue of the provision of this protective coating, the chip is protected from attack by moisture which may invade the chip encapsulation through cracks or gaps as was explained with reference to Fig. 1. The reliability of the mechanical connection between the lead frames and the silicon nitride film is ensured by virtue of the surfaces of the lead frames being plasma cleaned in advance of the silicon nitride film deposition.

In accordance with the experiments that we have conducted, the IR absorption spectrum of the deposited films showed a peak at 864 $cm^{-1}$ which is indicative of Si-N bondings. The withstand voltage level of the insulating coating was measured to be 8 x $10^6$ V/cm. The resistivity of the coating was measured to be 2 x $10^{-5}$ ohm centimeter. The reflective index of the coating was measured to be 1.7 to 1.8. The protection ability of the coating was evaluated by subjecting it to HF etching. The etching speed was from 3 to 10 angstroms/sec, which was substantially small as compared to the figure, about 30 angstroms/sec, of conventional silicon nitride coatings. Protection of an IC by means of such an excellent coating may be achieved by a coating of 1000 angstroms thickness for example (300 to 5000 angstroms in generally).

IC devices manufactured in accordance with the present invention were kept in 5% NaCl solution at 95°C for 20 hours and no appreciable change was detected. Also, IC devices manufactured in accordance with the present invention were subjected to PCT (pressure cooker test) under 10 atmospheres at 150°C for 100 hours and no defective IC's were found after the test. As compared to prior art IC's the fraction that was defective was decreased from 50 - 100 fits to 5 - 10 fits; one fit means $10^{-8}$.

After being kept in an atmosphere of 85°C and 85% relative humidity for 1000 hours, 500 IC devices manufactured in accordance with the present invention and both plasma cleaned and silicon nitride coated were exposed to molten solder at 260°C for 5 seconds in order to make electrical connections with circuits on a circuit board; no cracks or swellings appeared. As a comparison, 500 samples prepared without plasma cleaning and silicon nitride film coating were subjected to this test; as a result, 80 samples became unacceptable due to defects as illustrated in Fig. 1. 500 samples given the plasma cleaning treatment without silicon nitride film coating were also subjected to this test; as a result, 3 samples became unacceptable due to corrosion at the aluminium pads.

Whilst in the foregoing the invention has been described by reference to specific examples, it is to be appreciated that the invention is not limited to the particular examples described and that modifications and variations can be made without departing from the scope of the invention as defined by the appended claims. Thus, for example, diamond like carbon, silicon oxide or other insulating materials can be deposited to form the protective coating. Furthermore, although the embodiment described concerned IC chips, the present invention can be applied to other electric devices such as resistors and capacitors for example. Also, the present invention is effective in cases utilizing other bonding methods such as flip chip bonding and solder bump bonding.

The plasma cleaning can be made more effective if the plasma is further energized by IR irradiation at wavelengths of 10 to 15 micrometers or UV irradiation at wavelengths no longer than 300 nanometers.

In the above embodiment, the lead frames are of the dual-in-line type. However, the present invention can be applied to other types of lead frames such as the flat pack type.

## Claims

1. An electric device comprising:
a device proper having at least one surface which has been treasted by plasma cleaning; and
an enclosure made of an organic resin material encapsulating said device proper.

2. The device of claim 1 further comprising a protective coating made of an electrically insulating material covering the surface of said device proper.

3. The device of claim 2 wherein said protective coating is made of silicon nitride.

4. The device of any preceding claim wherein said device proper is an IC chip which is electrically connected with leads by means of wiring.

5. A method of manufacturing electric devices comprising:
making electrical connection between a device proper and at least one associated lead;
cleaning the surface of said device proper by plasma treatment; and
encapsulating said device proper and said lead in organic resin material with a portion of said at least one lead extending from the encapsulation.

6. The method of claim 5 wherein said plasma treatment is performed by glow discharge in a plasma source gas.

7. The method of claim 6 wherein said plasma source gas is argon.

8. The method of claim 5 or 6 or 7 further comprising coating said device proper and said at least one lead with an electrically insulating material.

9. The method of claim 8 wherein said electrically insulating material coating is provided by:
disposing said device proper and said lead between a pair of electrodes in the reaction chamber of a plasma CVD apparatus;
applying an alternating voltage between said electrodes in order to generate glow discharge;
inputting a reactive gas into said reaction chamber for forming said insulating material; and
depositing said insulating material on the surface of said device proper and said at least one lead.

10. The method of claim 9 wherein the frequency of said alternating voltage is from 1 to 500 MHz.

11. The method of any of claims 5 to 10 wherein a plurality of said devices proper are connected with a plurality of said leads which are integrally formed with a lead frame.

12. The method of claim 11 wherein said leads are separated from said lead frame after the encapsulation of the individual devices.

13. The method of any of claims 5 to 12 wherein said connection(s) between said device(s) proper and said lead(s) is (are) performed by wire bonding.

14. A method of manufacturing an encapsulated electronic device, such as a packaged integrated circuit for example, wherein the surfaces of the integrated circuit and of associated leads are subjected to plasma cleaning, and preferably also are coated with an electrically insulating material, prior to encapsulation of the device in a synthetic plastics material.

15. An encapsulated electronic device, such as a packaged integrated circuit for example, manufactured by the method of claim 14.

# F I G. 1

EP 0 354 056 A2

# F I G. 2

# F I G. 3 (A)

29

45

# F I G. 3 (B)

29

51'

C

41

35

39

35'

28

C

# F I G. 3 (C)

39

38

35'

35

44

2

29

# F I G . 4